# EUROPÄISCHE PATENTSCHRIFT

(11) **EP 1 383 235 B1**
(45) Veröffentlichungstag und Bekanntmachung des Hinweises auf die Patenterteilung: **26.11.2008**
(21) Anmeldenummer: 02015954.7
(22) Anmeldetag: 17.07.2002
(51) Int. Cl.: H03F 1/32, H03F 1/02

(54) **Verfahren und Vorrichtung zum Betreiben eines Sendeverstärkers**
Method and apparatus for operating a transmission amplifier
Procédé et dispositif de fonctionnement d'un amplificateur de transmission

(43) Veröffentlichungstag der Anmeldung: 21.01.2004
(73) Patentinhaber: Nokia Siemens Networks GmbH & Co. KG, 81541 München (DE)
(72) Erfinder: Bienek, Bernd, 46395 Bocholt (DE); Kern, Ralf, 46399 Bocholt (DE); Vollmer, Jürgen, Dr., 46419 Isselburg (DE)

(56) Entgegenhaltungen:
- GB-A- 2 356 093
- US-A- 5 420 536
- US-A- 6 043 707
- US-A- 6 141 541

## Beschreibung

Die Erfindung bezieht sich auf ein Verfahren beziehungsweise eine Vorrichtung zum Betreiben eines Sendeverstärkers gemäß dem Oberbegriff des Patentanspruch 1 beziehungsweise 7.

Eine solche Vorrichtung ist aus der US-A 6 043 707 bekannt. Hierbei erfolgt die Verstärkung linear oder leistungseffektiv in Abhängigkeit von der Signalleistung.

Ein Sendespektrum eines Kommunikationsendgerätes, beispielsweise eines Mobiltelefons, muss einschlägige Anforderungen, die in einzuhaltenden Standards niedergelegt sind, erfüllen. Dazu gehört, dass die Ausgangsleistung des Sendespektrums in benachbarten Funkkanälen aus den Standards entnehmbare Grenzwerte nicht überschreiten darf. Dies hat zur Folge, dass, abhängig von einer jeweiligen Modulationsart, die von dem Kommunikationsendgerät benutzt wird und bei der es sich beispielsweise um QPSK bei (W)CDMA handeln kann, für das Kommunikationsendgerät ein Sendeverstärker einzusetzen ist, an dessen Linearität sehr hohe Ansprüche gestellt werden.

Solche Sendeverstärker sind hochpreisig und verfügen über eine eher geringe Energieeffizienz.

Aus diesem Grund werden verbreitet, insbesondere bei Mobilfunk-Basisstationen, kostengünstigere Sendeverstärker verwendet, und diese weit bis in den nichtlinearen Bereich ihrer Kennlinie ausgesteuert, was zu einer hohen Leistungseffizienz führt. Die dadurch auftretende ausgeprägte Nichtlinearität wird mit einer Linearisierungstechnik kompensiert, indem die einkommenden digitalen Rohdaten mittels einer digitalen Vorverzerrungseinheit so verändert werden, dass im Ergebnis an einem Ausgang des Sendeverstärkers die tatsächlich gewünschte lineare Verstärkung geliefert wird.

Die Vorverzerrungseinheit gleicht somit die Nichtlinearität des Sendeverstärkers und ggf. weiterer elektronischer Bauelemente, welche die Datenwerte beeinflussen, mit Hilfe geeigneter Vorverzerrungswerte für die digitalen Datenwerte aus.

Ausgehend hiervon liegt der Erfindung die Aufgabe zugrunde, ein Verfahren und eine Vorrichtung bereit zu stellen, die es gestatten, bei Kommunikationsendgeräten energieeffiziente Sendeverstärker einzusetzen, die selbst hohen Anforderungen an ihre Linearisierung genügen.

Diese Aufgabe wird hinsichtlich des Verfahrens gelöst durch ein Verfahren mit den Merkmalen des Anspruchs 1.

Danach ist, ausgehend von dem eingangs beschriebenen Verfahren, vorgesehen, dass wenigstens zu Beginn des Sendebetriebs oder nach einer erheblichen Betriebsparameteränderung der Sendeverstärker mit einer Versorgungsspannung betrieben wird, die so bemessen ist, dass der Sendeverstärker im linearen Bereich arbeitet und die Versorgungsspannung des Sendeverstärkers im wesentlichen in dem Maße verringert wird, in dem eine Güte des Ausgleichs der Nichtlinearität des Sendeverstärkers durch die Vorverzerrungseinheit zunimmt.

Die grundliegende Idee der Erfindung besteht somit darin, gerade in der Anfangsphase eines Sendebetriebes den Sendeverstärker mit einer derart hoch bemessenen Versorgungsspannung zu betreiben, dass er in seinem linearen Bereich arbeitet. Anders ausgedrückt, wird der Sendeverstärker mit einem genügend großen "Back Off" für seinen linearen Betrieb vorgesehen.

Im Anschluss daran wird die Versorgungsspannung, abhängig von der Güte des Ausgleichs der Nichtlinearität des Sendeverstärkers durch die Vorverzerrungseinheit, immer weiter heruntergefahren, bis ein für dauerhaften Sendebetrieb geeigneter Wert für die Versorgungsspannung erreicht wird.

Bevorzugt werden zur Steuerung der Versorgungsspannung des Sendeverstärkers fortlaufend Messwerte für die Güte des Ausgleichs der Nichtlinearität des Sendeverstärkers durch die Vorverzerrungseinheit dienen.

Wie bereits bei der Beschreibung des Standes der Technik erwähnt, gleicht die Vorverzerrungseinheit Nichtlinearitäten des Sendeverstärkers aus. Dazu muss gerade in der Anfangsphase eines Sendebetriebs zunächst nach geeigneten Vorverzerrungsfaktoren für einkommende Datenwerte gesucht werden, was beispielsweise mittels einer Rückkopplung von Ausgangs-Datenwerten, die den Sendeverstärker durchlaufen haben, ermöglicht wird.

Es wird als bevorzugt angesehen, dass als Messwerte Differenzwerte zwischen von dem Leistungsverstärker aus zu der Vorverzerrungseinheit rückgekoppelten Datenwerten und Datenwerten des Eingangs-Datenstroms verwendet werden. In diesem Zusammenhang ist es günstig, wenn jeweils über eine repräsentative Anzahl von Eingangs-Datenwerten und rückgekoppelten Datenwerten gemittelt wird. Im einzelnen beruht der Vergleich zwischen Eingangs-Datenwerten und rückgekoppelten Datenwerten darauf zu überprüfen, ob für sämtliche Datenwerte der Sendeverstärker den gewünschten Verstärkungsfaktor bereitstellt und damit linearisiert ist. Anders ausgedrückt, es wird überprüft, ob die Nichtlinearität des Sendeverstärkers durch die von der Vorverzerrungseinheit festgelegten Vorverzerrungsfaktoren ausgeglichen wird.

Ausgehend von den Beträgen der Differenzwerte kann die Versorgungsspannung immer dann um einen Betrag vermindert werden, wenn die Differenzwerte, die zur Rauschunterdrückung vorzugsweise gemittelt werden, einen Schwellwert unterschreiten. Auf diese Weise wird erreicht, dass die Versorgungsspannung schrittweise vermindert werden kann und zwar in dem Maße, wie die Differenzwerte sinken.

Es wird als bevorzugt angesehen, dass die Messwerte von der Vorverzerrungseinheit aus einer adaptiven Regelung für die Versorgungsspannung des Sendverstärkers zugeleitet werden. Diese adaptive Regelung nimmt unmittelbar Einfluss auf die Versorgungsspannung und legt somit dien Rahmen fest, innerhalb dem die Vorverzerrungseinheit ihre Linearisierungsaufgabe zu bewerkstelligen hat. Desto geringer die Versorgungsspannung gewählt wird, desto stärker greift die Vorverzerrungseinheit zur Linearisierung ein, da mit abnehmender Versorgungsspannung grundsätzlich die Nichtlinearität des Sendeverstärkers zunimmt. Daher wird auch der Fall auftreten, bei dem die Versorgungsspannung eine technische Grenze derart unterschreitet, dass die Vorverzerrungseinheit ihre Aufgabe der Linearisierung des Senderverstärkers nicht mehr erfüllen kann, so dass es erforderlich ist, dass die adaptive Regelung eine Erhöhung der Versorgungsspannung vornimmt. Insofern wirken die Vorverzerrungseinheit und die adaptive Regelung zusammen.

Die oben genannte Aufgabe wird hinsichtlich der Vorrichtung gelöst durch eine Vorrichtung mit den Merkmalen des Anspruchs 7. Bevorzugte Ausführungsformen der Vorrichtung sind in den Ansprüchen 8 und 9 niedergelegt. Ihre Merkmale sind bereits oben anhand der Beschreibung des Verfahrens erläutert.

Ein Ausführungsbeispiel der Erfindung wird nachfolgend anhand der Zeichnungen noch näher erläutert. Es zeigen:
- Figur 1: ein Blockschaltbild einer Vorrichtung zum Betreiben eins Sendeverstärkers eines mobilen Kommunikationsendgerätes und
- Figuren 2, 3, 4, 5 und 6: jeweils zeitliche Verläufe wichtiger Betriebsparameter des Sendeverstärkers in einer Anfangsphase eines Sendebetriebs.

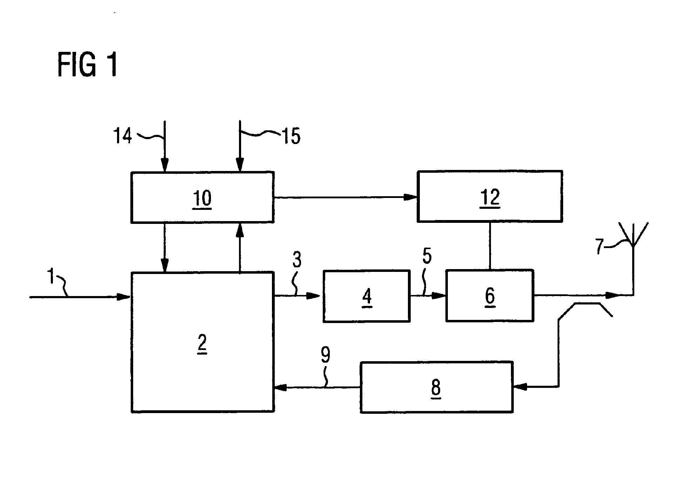

Wie aus dem Blockdiagramm von Figur 1 hervorgeht, wird ein einkommender Datenstrom 1 einer adaptiven Vorverzerrungseinheit 2 für eine adaptive digitale Vorverzerrung (im Englischen auch unter dem Begriff "predistortion" bekannt) zugeleitet. Ein vorverzerrter Datenstrom 3 gelangt von der Vorverzerrungseinheit 2 zu einer Wandler-/Modulatoreinheit 4, in der der vorverzerrte Datenstrom von digital zu analog gewandelt und einem Trägersignal aufmoduliert wird. Ein Ausgangssignal 5 der Wandler-/Modulatoreinheit 4 wird einem Sendeverstärker 6 zugeführt, dessen Ausgangssignal über eine Antenne 7 eines Kommunikationsendgerätes ausgestrahlt wird.

Der Sendeverstärker 6 wird im Normalbetrieb mit einer Versorgungsspannung VPA betrieben, bei der er eine nichtlineare Kennlinie für den einkommenden Datenstrom 1 aufweist, so dass eine Vorverzerrung durch die Vorverzerrungseinheit 2 zur Liniearisierung erforderlich ist. Aus diesem Grund werden für die Ausgangssignale des Sendeverstärkers 6 repräsentative analoge Signale über einen Rückkopplungszweig 8 (Messzweig) zurückgeführt und über einen Analog-/Digitalwandler der Vorverzerrungseinheit 2 zugeführt.

Der Rückkopplungszweig 8 ist aus dem folgenden Grund sinnvoll: Sind die die Kennlinie des Sendeverstärkers 6 beeinflussenden Parametern, wie Temperatur und Versorgungsspannung, nicht konstant, wie man das in einer Mobilfunk-Basisstation annehmen kann, so ändern sich die zur Linearisierung des Sendeverstärkers 6 notwendigen Vorverzerrungsfaktoren. Dann ist es angemessen, dass mindestens ein Rückkopplungszweig vorhanden ist, der darüber Aufschluss gibt, inwieweit der Ausgleich der Nichtlinearität hauptsächlich des Sendeverstärkers 6 durch die Vorverzerrungseinheit 2 zufriedenstellend ist. Mit Hilfe der mit dem Rückkopplungszweig 8 gewonnen Information können die Vorverzerrungswerte für die Vorverzerrungseinheit 2, soweit erforderlich, korrigiert werden.

Letztgenannte Vorgehensweise trägt der Tatsache Rechnung, dass beim Einschalten eines Senders des Kommunikationsendgerätes die Linearisierung mittels der Vorverzerrungseinheit 2 noch nicht eingeschwungen ist und somit nicht korrekt arbeitet, was auch bei erheblichen Betriebsparameteränderungen während des Sendebetriebs auftreten kann (Temperatursprung). In diesem Fall führen die nichtlinearen Verzerrungen des Sendeverstärkers 6 zu einer verminderten Signalqualität, die sich unter anderem in einer erhöhten Störleistung in benachbarten Funkkanälen niederschlägt. Insbesondere für Mobilfunkstandards, bei denen auch eine kurzzeitig erhöhte Störung benachbarter Funkkanäle nicht zugelassen ist, ist die beschriebene Linearisierungstechnik vorteilhafte

Bei diesem Ausführungsbeispiel wird innerhalb der Vorverzerrungseinheit 2 ein Vergleich zwischen einkommenden Datenwerten und rückgekoppelten Datenwerten gezogen, so dass sich entsprechende Differenzwerte ergeben. Sobald diese Differenzwerte im Mittel einen unteren Schwellwert unterschreiten, informiert die Vorverzerrungseinheit 2 eine adaptive Regelung 10 für eine Versorgungsspannung VPA des Sendeverstärkers 6 über diese Tatsache, und zwar über eine Signalleitung 11. Die adaptive Regelung 10 steuert einen DC-DC-Konverter 12, bei dem es sich um eine einstellbare Spannungsversorgung für den Sendeverstärker 6 handelt, so dass aufgrund des Unterschreitens des vorgegebenen unteren Schwellwerts für die Differenzwerte die Versorgungsspannung VPA für den Sendeverstärker 6 um ein bestimmtes Intervall vermindert wird. Die Information darüber wird auch von der adaptiven Regelung 10 über eine Signalleitung 13 der Vorverzerrungseinheit 2 zugeleitet.

Für die Versorgungsspannung VPA des Sendeverstärkers 6 ist eine Schrittweite definiert, die ein schrittweises Absenken bzw. Erhöhen der Versorgungsspannung VPA des Sendeverstärkers 6 bewirkt.

Wenn beispielsweise über die Signalleitung 11 die Vorverzerrungseinheit 2 der adaptiven Regelung 10 anzeigt, dass der Betrag der Differenzwerte zwischen einkommenden Datenwerten 1 und rückgekoppelten Datenwerten 9 zunimmt, so daß ein oberer Schwellwert für die Differenzwerte überschritten wird, veranlasst die adaptive Regelung 10 den Konverter 12 zur Erhöhung der Versorgungsspannung VPA um ein vorbestimmtes Spannungsintervall. Gleichzeitig nimmt die Vorverzerrungseinheit eine Anpassung der Vorverzerrungsfaktoren vor.

Die anhand von Figur 1 beschriebene Vorrichtung gestattet es, den Sendeverstärker 6 zunächst mit einer derart hohen Versorgungsspannung VPA zu betreiben, dass der Sendeverstärker 6 in seinem linearen Bereich arbeitet, so dass zu diesem Zeitpunkt die Vorverzerrungseinheit 2 zur Linearisierung nicht erforderlich ist. Im Bereich der "Anfangsphase" eines Sendebetriebs werden dann die Differenzwerte zwischen rückgekoppelten Datenwerten 9 und einkommenden Datenwerten 1 im Normalfall in dem Maße, wie die Vorverzerrungsfaktoren optimiert werden, abnehmen, so dass die Differenzwerte den oberen Schwellwert, der jeweils eine Verminderung der Versorgungsspannung VPA auslösen soll, mehrmals unterschreiten. Die Versorgungsspannung VPA sinkt schrittweise entsprechend, wobei mit jeder Änderung der Versorgungsspannung VSP grundsätzlich jeweils eine neue Optimierung der Vorverzerrungsfaktoren zu erfolgen hat, da sich die Kennlinie der Sendeverstärkers 6 ändert. Dabei sollte ein Differenzwert-Bereich vorgesehen sein, bei dem eine Änderung der Versorgungsspannung nicht stattfindet und der durch einen oberen und den unteren Schwellwert festgelegt ist. Wird der obere Schwellwert überschritten, ist die Versorgungsspannung VSP um einen vorbestimmten Betrag anzuheben. Insofern ergibt sich ein Verlauf der adaptiven Regelung 10 entsprechend einer Hysterese.

Es ist hervorzuheben, dass das Vorsehen von Schwellwerten für die Differenzwerte nicht zwingend erforderlich ist. Es kann auch eine kontinuierliche Steuerung der Versorgungsspannung VPA abhängig von aktuellen Differenzwerten vorgesehen sein, wenn die Versorgungsspannung VPA, abhängig von aktuellen Differenzwerten, kontinuierlich geregelt werden kann. Außerdem muss die Schrittweite für die Verminderung/Erhöhung der Versorgungsspannung VPA nicht notwendiger Weise konstant sein.

Als wichtigste Sensorwerte für die adaptive Regelung 10 werden bei der Ausführungsform nach Figur 1 Temperaturwerte 14 und Batteriespannungswerte 15 zugeführt, die ebenfalls den Betrieb des Sendeverstärkers 6 beeinflussen.

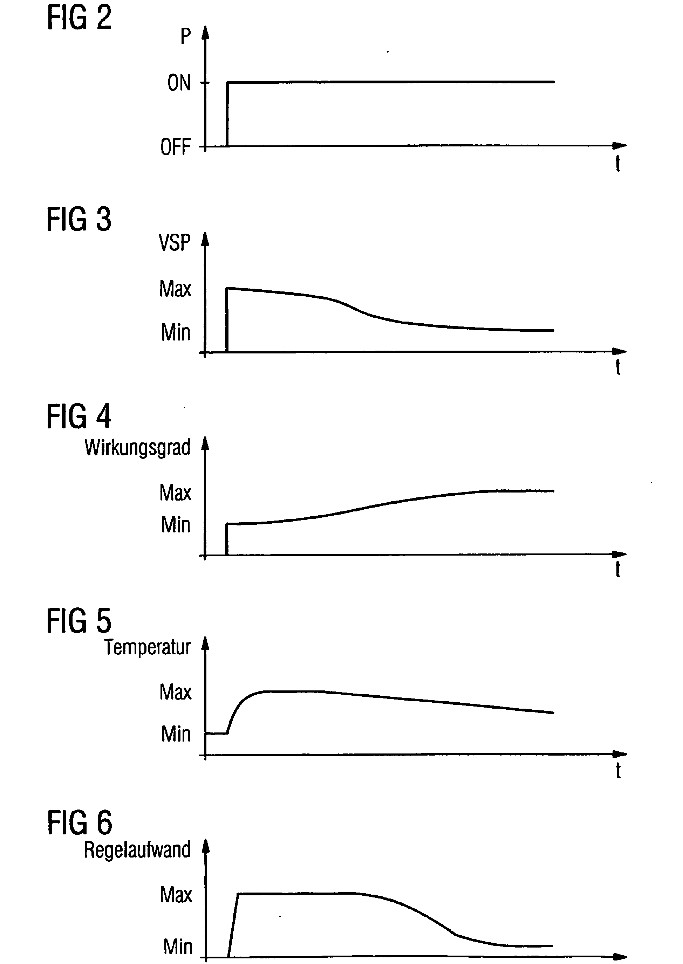

Aus der Figur 2, in der die Sendeleistung P der Antenne 7 gegen die Zeit aufgetragen ist, geht hervor, dass diese sich nach einer Aufnahme eines Sendebetriebs konstant verhält. Figur 3 zeigt den zeitlichen Verlauf der Versorgungsspannung VPA für den Sendeverstärker 2, der zunächst eine derart hohe Versorgungsspannung VPA erhält, dass er im linearen Bereich arbeitet, wonach die Versorgungsspannung kontinuierlich abnimmt und später einen im wesentlichen konstanten Wert annimmt. In der Figur 4 ist der zeitliche Verlauf des Wirkungsgrades des Sendeverstärkers 2 angegeben, der nach dem Einschwingen gegen einen erhöhten Wert konvergiert. Aus der Figur 5 geht der Temperaturverlauf über die Zeit für den Sendeverstärker 2 hervor, wobei die Temperatur bei Aufnahme des Sendebetriebs zunächst ansteigt und dann kontinuierlich auf einen im wesentlichen konstanten Wert absinkt. Von großer Bedeutung ist der in Figur 6 aufgetragene Regelaufwand der Vorverzerrungseinheit 2. Es ist erkennbar, dass in der Anfangsphase des Sendebetriebs der Regelaufwand zunächst sehr stark ansteigt, dann etwa gleichbleibend ist und anschließend kontinuierlich bis auf einen im wesentlichen konstanten Wert absinkt, wobei die letztere Phase darauf beruht, dass für die Vorverzerrungseinheit geeignete Vorverzerrungsfaktoren für den einkommenden Datenstrom gefunden sind. Unter Regelaufwand ist dabei die Zahl der erforderlichen Anpassungsvorgänge für die Vorverzerrungsfaktoren der Vorverzerrungseinrichtung 2 pro Zeiteinheit zu verstehen.

Der Ablauf des oben beschriebenen Verfahrens bzw. die Funktion der Vorrichtung sind identisch für eine Anfangsphase eines Sendebetriebs und ein plötzliches Auftreten einer Betriebsparameteränderung. Wenn beispielsweise ein plötzlicher Temperatursprung auftritt, wird der obere Schwellwert für die Differenzwerte um ein hohes Maß überschritten. Sofern die Differenzwerte eine Steigung zeigen, die eine vorbestimmte Steigung überschreiten, kann die Versorgungsspannung VSP sprunghaft auf einen Wert angehoben werden, bei dem der Sendeverstärker 6 auch im wesentlichen ohne Eingriff der Vorverzerrungseinheit 2, bei der dann ggf. die Vorverzerrungsfaktoren auf einen konstanten Wert zurückzusetzen sind, linear arbeitet. Um einen Sprung der Ausgangsleistung des Sendeverstärkers 6 zu vermeiden, sollte der konstante Wert so gewählt werden, dass der Verstärkungsfaktor, der sich aus der Kombination der Vorverzerrungseinheit 2, dem Digital-/Analogwandler 4 und dem Sendeverstärker 6 ergibt, vor und nach der Erhöhung der Versorgungsspannung VPA unverändert bleibt.

Selbstverständlich kann das verfahren auch über einen gesamten Sendebetrieb des Sendeverstärkers 6 durchgeführt werden, wobei die Versorgungsspannung VSP bei Überschreiten des oberen Schwellwertes für die Differenzwerte um einen Betrag erhöht und bei Unterschreiten des unteren Schwellwertes für die Differenzwerte um einen Betrag erhöht wird. Bei einer Steigung der Differenzwerte oberhalb der vorbestimmten Steigung oder zu Beginn des Sendebetriebs kann im Extremfall eine sprunghafte Erhöhung der Versorgungsspannung VSP für einen linearen Betrieb des Sendeverstärkers 6 vorgenommen werden.

## Patentansprüche

1. Verfahren zum Betreiben eines Sendeverstärkers (6), wobei der Sendeverstärker (6) mit einer Versorgungsspannung gespeist und eine Nichtlinearität des Sendeverstärkers (6) mittels einer Vorverzerrungseinheit (2) für Datenwerte eines Eingangs-Datenstroms (1) im wesentlichen ausgeglichen wird,
**dadurch gekennzeichnet,**
**dass** wenigstens zu Beginn des Sendebetriebs oder nach einer erheblichen Betriebsparameteränderung der Sendeverstärker (6) mit einer Versorgungsspannung betrieben wird, die so bemessen ist, dass der Sendeverstärker (6) im linearen Bereich arbeitet und
die Versorgungsspannung des Sendeverstärkers (6) im wesentlichen in dem Maße verringert wird, in dem eine Güte des Ausgleichs der Nichtlinearität des Sendeverstärkers (6) durch die Vorverzerrungseinheit (2) zunimmt.

2. Verfahren nach Anspruch 1,
**dadurch gekennzeichnet,**
**dass** zur Steuerung der Versorgungsspannung des Sendeverstärkers (6) fortlaufend Messwerte für die Güte des Ausgleichs der Nichtlinearität des Sendeverstärkers (6) durch die Vorverzerrungseinheit (2) dienen.

3. Verfahren nach Anspruch 2,
**dadurch gekennzeichnet,**
**dass** als Messwerte Differenzwerte zwischen von dem Sendeverstärker (6) aus zu der Vorverzerrungseinheit (2) rückgekoppelten Datenwerten und Datenwerten des Eingangs-Datenstroms (1) verwendet werden.

4. Verfahren nach Anspruch 3,
**dadurch gekennzeichnet,**
**dass** die Versorgungsspannung (VPA) jeweils um einen Betrag vermindert wird, wenn die Differenzwerte einen Schwellwert mit einer vorgegebenen Wahrscheinlichkeit unterschreiten.

5. Verfahren nach Anspruch 4,
**dadurch gekennzeichnet,**
**dass** die Differenzwerte aufgrund der Bildung repräsentativer Mittelwerte für die Datenwerte des Eingangs-Datenstroms (1) und der rückgekoppelten Datenwerte (9) gewonnen werden.

6. Verfahren nach einem der Ansprüche 2 bis 5,
**dadurch gekennzeichnet,**
**dass** die Messwerte von der Vorverzerrungseinheit (2) aus einer adaptiven Regelung (10) für die Versorgungsspannung des Sendeverstärkers (6) zugeleitet werden.

7. Vorrichtung zum Betreiben eines Sendeverstärkers (6) mit einer Vorverzerrungseinheit (2) für Datenwerte eines Eingangs-Datenstroms (1) zum Ausgleichen einer Nichtlinearität des Sendeverstärkers (6),
**dadurch gekennzeichnet,**
**dass** ein adaptiver Regler (10) zum Steuern einer Spannungsversorgung (12) für den Sendeverstärker (6) vorgesehen ist, wobei der Regler (10) mit der Vorverzerrungseinheit (2) zusammenwirkt, wobei wenigstens zu Beginn des Sendebetriebs oder nach einer erheblichen Betriebsparameteränderung der Sendeverstärker (6) mit einer Versorgungsspannung betrieben wird, die so bemessen ist, dass der Sendeverstärker (6) im linearen Bereich arbeitet und
die Versorgungsspannung des Sendeverstärkers (6) im wesentlichen in dem Maße verringert wird, in dem eine Güte des Ausgleichs der Nichtlinearität des Sendeverstärkers (6) durch die Vorverzerrungseinheit (2) zunimmt.

8. Vorrichtung nach Anspruch 7,
**dadurch gekennzeichnet,**
**dass** die Vorverzerrungseinheit (2) zum Bilden von Differenzwerten zwischen von dem Sendeverstärker (6) aus zu der Vorverzerrungseinheit (2) rückgekoppelten Datenwerten (9) und Datenwerten des Eingangsstromes (1) und zum Übermitteln dieser Differenzwerte an den adaptiven Regler (10) ausgebildet ist.

9. Vorrichtung nach Anspruch 8,
**dadurch gekennzeichnet,**
**dass** der adaptive Regler (10) zum Umsetzen der Differenzwerte zur Steuerung der Spannungsversorgung (12) des Sendeverstärkers (6) ausgebildet ist.

## Claims

1. Method for operation of a transmission amplifier (6), with the transmission amplifier (6) being fed with a supply voltage and with any nonlinearity of the transmission amplifier (6) being essentially compensated for by means of a predistortion unit (2) for data values in an input data stream (1),
**characterized**
**in that,** at least at the start of transmission operation or after a considerable change in the operating parameters, the transmission amplifier (6) is operated with a supply voltage which is of such a magnitude that the transmission amplifier (6) operates in the linear region, and
the supply voltage for the transmission amplifier (6) is essentially reduced to the extent to which a quality factor for the compensation for the nonlinearity of the transmission amplifier is increased by the predistortion unit (2).

2. Method according to Claim 1,
**characterized**
**in that** measurement values for the quality of the compensation for the nonlinearity of the transmission amplifier (6) by the predistortion unit (2) are used continuously to control the supply voltage for the transmission amplifier (6).

3. Method according to Claim 2,
**characterized**
**in that** difference values between data values which are fed back from the transmission amplifier (6) to the predistortion unit (2) and data values in the input data stream (1) are used as measurement values.

4. Method according to Claim 3,
**characterized**
**in that** the supply voltage (VPA) is in each case reduced by an amount when the difference values fall below a threshold value with a predetermined probability.

5. Method according to Claim 4,
**characterized**
**in that** the difference values are obtained by forming representative mean values for the data values in the input data stream (1) and the fed-back data values (9).

6. Method according to one of Claims 2 to 5,
**characterized**
**in that** the measurement values are passed by the predistortion unit (2) from an adaptive regulator (10) for the supply voltage for the transmission amplifier (6).

7. Apparatus for operation of a transmission amplifier (6) having a predistortion unit (2) for data values in an input data stream (1) in order to compensate for any nonlinearity of the transmission amplifier (6),
**characterized**
**in that** an adaptive regulator (10) is provided for controlling a voltage supply (12) for the transmission amplifier (6), with the regulator (10) interacting with the predistortion unit (2), in which case, at least at the start of transmission operation or after a considerable operating-parameter change, the transmission amplifier (6) is operated with a supply voltage which is of such a magnitude that the transmission amplifier (6) operates in the linear range and the supply voltage for the transmission amplifier (6) is reduced essentially to the same extent that a Q-factor of the compensation for the nonlinearity of the transmission amplifier (6) by the predistortion unit (2) increases.

8. Apparatus according to Claim 7,
**characterized**
**in that** the predistortion unit (2) is designed to form difference values between data values (9), which are fed back from the transmission amplifier (6) to the predistortion unit (2), and data values in the input stream (1), and to transmit these difference values to the adaptive regulator (10).

9. Apparatus according to Claim 8,
**characterized**
**in that** the adaptive regulator (10) is designed to convert the difference values for controlling the voltage supply (12) of the transmission amplifier (6).

## Revendications

1. Procédé pour exploiter un amplificateur d'émission (6), l'amplificateur d'émission (6) étant alimenté avec une tension d'alimentation et une non-linéarité de l'amplificateur d'émission (6) étant composée sensiblement au moyen d'une unité de prédistorsion (2) pour des valeurs de données d'un flux de données d'entrée (1),
**caractérisé en ce que,**
au moins au début du mode d'émission ou après une modification importante des paramètres de service, l'amplificateur d'émission (6) est exploité avec une tension d'alimentation qui est calculée telle que l'amplificateur d'émission (6) travaille dans la plage linéaire et
la tension d'alimentation de l'amplificateur d'émission (6) est réduite sensiblement dans la mesure où une qualité de la compensation de la non-linéarité de l'amplificateur d'émission (6) par l'unité de prédistorsion (2) augmente.

2. Procédé selon la revendication 1,
**caractérisé en ce que,**
pour la commande de la tension d'alimentation de l'amplificateur d'émission (6), on utilise de façon continue des valeurs de mesure pour la qualité de la compensation de la non-linéarité de l'amplificateur d'émission (6) par l'unité de prédistorsion (2).

3. Procédé selon la revendication 2,
**caractérisé en ce que,**
comme valeurs de mesure, on utilise des valeurs de différence entre des valeurs de données réinjectées à partir de l'amplificateur d'émission (6) dans l'unité de prédistorsion (2) et des valeurs de données du flux de données d'entrée (1).

4. Procédé selon la revendication 3,
**caractérisé en ce que**
la tension d'alimentation (VPA) est réduite d'un montant lorsque les valeurs de différence sont inférieures à une valeur seuil avec une probabilité prédéfinie.

5. Procédé selon la revendication 4,
**caractérisé en ce que**
les valeurs de différence sont obtenues sur la base de la formation de valeurs moyennes représentatives pour les valeurs de données du flux de données d'entrée (1) et des valeurs de données (9) réinjectées.

6. Procédé selon l'une quelconque des revendications 2 à 5,
**caractérisé en ce que**
les valeurs de mesure sont acheminées à partir de l'unité de prédistorsion (2) à un réglage (10) adaptatif pour la tension d'alimentation de l'amplificateur d'émission (6).

7. Dispositif pour exploiter un amplificateur d'émission (6) avec une unité de prédistorsion (2) pour des valeurs de données d'un flux de données d'entrée (1) pour la compensation d'une non-linéarité de l'amplificateur d'émission (6),
**caractérisé en ce que**
un régulateur (10) adaptatif est prévu pour la commande d'une tension d'alimentation (12) pour l'amplificateur d'émission (6), le régulateur (10) coopérant avec l'unité de prédistorsion (2), l'amplificateur d'émission (6) étant exploité, au moins au début du mode d'émission ou après une modification importante des paramètres de service, avec une tension d'alimentation qui est calculée telle que l'amplificateur d'émission (6) travaille dans la plage linéaire et que la tension d'alimentation de l'amplificateur d'émission (6) soit réduite sensiblement dans la mesure où une qualité de la compensation de la non-linéarité de l'amplificateur d'émission (6) par l'unité de prédistorsion (2) augmente.

8. Dispositif selon la revendication 7,
**caractérisé en ce que**
l'unité de prédistorsion (2) est conçue pour former des valeurs de différence entre des valeurs de données (9) réinjectées à partir de l'amplificateur d'émission (6) vers l'unité de prédistorsion (2) et des valeurs de données du flux d'entrée (1) et pour transmettre ces valeurs de différence au régulateur (10) adaptatif.

9. Dispositif selon la revendication 8,
**caractérisé en ce que**
le régulateur (10) adaptatif est conçu pour la conversion des valeurs de différence pour la commande de la tension d'alimentation (12) de l'amplificateur d'émission (6).
